(19) Europäisches Patentamt / European Patent Office / Office européen des brevets

(11) **EP 3 079 150 B1**

(12) **EUROPEAN PATENT SPECIFICATION**

(45) Date of publication and mention
of the grant of the patent:
**11.09.2019 Bulletin 2019/37**

(21) Application number: **14891093.8**

(22) Date of filing: **01.12.2014**

(51) Int Cl.:
*G10L 19/02* (2013.01)      *G10L 19/002* (2013.01)

(86) International application number:
**PCT/CN2014/092695**

(87) International publication number:
**WO 2015/165264 (05.11.2015 Gazette 2015/44)**

(54) **SIGNAL PROCESSING METHOD AND DEVICE**

SIGNALVERARBEITUNGSVERFAHREN UND -VORRICHTUNG

PROCÉDÉ ET DISPOSITIF DE TRAITEMENT DE SIGNAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.04.2014 CN 201410177234**

(43) Date of publication of application:
**12.10.2016 Bulletin 2016/41**

(60) Divisional application:
**19181139.7**

(73) Proprietor: **Huawei Technologies Co., Ltd.
Longgang District
Shenzhen, Guangdong 518129 (CN)**

(72) Inventors:
• **WANG, Bin
Shenzhen,
Guangdong 518129 (CN)**
• **MIAO, Lei
Shenzhen,
Guangdong 518129 (CN)**
• **LIU, Zexin
Shenzhen,
Guangdong 518129 (CN)**

(74) Representative: **Kreuz, Georg Maria
Huawei Technologies Duesseldorf GmbH
Riesstraße 25
80992 München (DE)**

(56) References cited:
WO-A1-2007/041789      CN-A- 101 727 906
CN-A- 101 770 775      CN-A- 102 436 820
CN-A- 103 366 750      CN-A- 103 544 957
JP-A- 2005 258 478      JP-A- 2008 309 955
US-A1- 2012 290 305      US-A1- 2012 290 305

**Description**

**TECHNICAL FIELD**

The present invention relates to the signal processing field, and specifically, to a signal processing method and device.

**BACKGROUND**

In current communication transmission, increasing attention is paid to quality of a speech signal or an audio signal; therefore, a requirement for signal encoding and decoding is increasingly high. In an existing frequency domain encoding algorithm, bit allocation is generally performed on each sub-band of a signal directly according to a size of a frequency envelope, and then each sub-band is encoded by using a quantity of allocated bits. However, practice shows that, in these existing encoding algorithms, a sub-band of a low frequency band has relatively large impact on signal encoding quality; therefore, the sub-band of the low frequency band generally becomes a bottleneck of signal encoding performance. In addition, the foregoing bit allocation manner cannot well adapt to a bit requirement of each sub-band, especially that of a sub-band of a low frequency band, which leads to relatively poor signal encoding performance. Correspondingly, signal decoding performance is also relatively poor.

JP 2005 258478 A discloses an encoding device, wherein a down sampler decreases the sampling rate of an input signal from a sampling rate FH to a sampling rate FL, a basic layer encoder encodes a sound signal with the sampling rate FL, a local decoder decodes the encoded code outputted from the basic layer encoder, an up sampler increases the sampling rate of the decoded signal to the sampling rate FH, a subtractor subtracts the decoded signal from the sound signal with the sampling rate FH, and an extended layer encoder encodes the signal outputted from the subtractor by using parameters of the decoding result outputted from the local decoder.

**SUMMARY**

The present invention provides a signal processing method and device, which can improve signal encoding and decoding performance.

The present invention is defined in the independent claims.

According to a first aspect, a signal processing method for processing an audio signal or a speech signal is provided, including: selecting M sub-bands from N sub-bands, where the N sub-bands are obtained by dividing spectral coefficients of a current frame of a signal, a frequency band of the M sub-bands is lower than a frequency band of K sub-bands in the N sub-bands except the M sub-bands, N is a positive integer greater than 1, both M and K are positive integers, and the sum of M and K is N; determining, according to performance information of the M sub-bands, to perform a modification operation on original envelope values of the M sub-bands, where the performance information is used to indicate an energy characteristic and a spectral characteristic that are of the M sub-bands; performing modification on the original envelope values of the M sub-bands, so as to acquire modified envelope values of the M sub-bands; and performing first bit allocation on the N sub-bands according to the modified envelope values of the M sub-bands and original envelope values of the K sub-bands.

With reference to the first aspect, the determining, according to performance information of the M sub-bands, to perform a modification operation on original envelope values of the M sub-bands includes:

  determining a first parameter according to original envelope values of the N sub-bands, where the first parameter indicates a concentration degree that is of spectral energy of the signal and that is on the M sub-bands;
  determining a second parameter according to the original envelope values of the M sub-bands, where the second parameter indicates a degree of spectral fluctuation of the M sub-bands; and
  determining, in a case in which the first parameter falls within a first range and the second parameter falls within a second range, to perform the modification operation on the original envelope values of the M sub-bands.

In a possible implementation manner, the determining a first parameter according to original envelope values of the N sub-bands includes: determining total energy of the M sub-bands according to the original envelope values of the M sub-bands; determining total energy of the K sub-bands according to the original envelope values of the K sub-bands; and determining a ratio of the total energy of the M sub-bands to the total energy of the K sub-bands as the first parameter.

In a possible implementation manner, the determining a second parameter according to the original envelope values of the M sub-bands includes: determining the total energy of the M sub-bands and energy of a first sub-band according to the original envelope values of the M sub-bands, where the energy of the first sub-band is the largest in that of the M sub-bands; and determining a ratio of the energy of the first sub-band to the total energy of the M sub-bands as the second parameter.

In a possible implementation manner, the performing modification on the original envelope values of the M sub-bands, so as to acquire modified envelope values of the M sub-bands includes: determining the total energy of the M sub-bands and the energy of the first sub-band according to the original envelope values of the M sub-bands, where the energy of the first sub-band is the largest in that of the M sub-bands; determining a modification factor according to the total energy of the M sub-bands and the energy of the first sub-band; and performing modification on the original envelope values of the M sub-bands by using the modification factor, so as to acquire the modified envelope values of the M sub-bands.

In a possible implementation manner, a modified envelope value of each sub-band in the M sub-bands is greater than an original envelope value of the same sub-band.

In a possible implementation manner, the method further includes: determining a quantity of redundant bits of each sub-band in the N sub-bands according to quantities of bits respectively allocated to the N sub-bands during the first bit allocation, where the quantity of redundant bits of each sub-band in the N sub-bands is less than a quantity of bits required for encoding a single information unit in the same sub-band; determining a total quantity of redundant bits according to the quantity of redundant bits of each sub-band in the N sub-bands; and performing second bit allocation on the N sub-bands according to the modified envelope values of the M sub-bands, the original envelope values of the K sub-bands, and the total quantity of redundant bits.

According to a second aspect, a signal processing device for processing an audio signal or a speech signal is provided, including: a selection unit, configured to select M sub-bands from N sub-bands, where the N sub-bands are obtained by dividing spectral coefficients of a current frame of a signal, a frequency band of the M sub-bands is lower than a frequency band of K sub-bands in the N sub-bands except the M sub-bands, N is a positive integer greater than 1, both M and K are positive integers, and the sum of M and K is N; a determining unit, configured to determine, according to performance information of the M sub-bands, to perform a modification operation on original envelope values of the M sub-bands, where the performance information is used to indicate an energy characteristic and a spectral characteristic that are of the M sub-bands; a modification unit, configured to perform modification on the original envelope values of the M sub-bands, so as to acquire modified envelope values of the M sub-bands; and an allocation unit, configured to perform first bit allocation on the N sub-bands according to the modified envelope values of the M sub-bands and original envelope values of the K sub-bands.

With reference to the second aspect, the determining unit is specifically configured to: determine a first parameter according to original envelope values of the N sub-bands, where the first parameter indicates a concentration degree that is of spectral energy of the signal and that is on the M sub-bands; determine a second parameter according to the original envelope values of the M sub-bands, where the second parameter indicates a degree of spectral fluctuation of the M sub-bands; and determine, in a case in which the first parameter falls within a first range and the second parameter falls within a second range, to perform the modification operation on the original envelope values of the M sub-bands.

In a possible implementation manner, the determining unit is specifically configured to: determine total energy of the M sub-bands according to the original envelope values of the M sub-bands; determine total energy of the K sub-bands according to the original envelope values of the K sub-bands; and determine a ratio of the total energy of the M sub-bands to the total energy of the K sub-bands as the first parameter.

In a possible implementation manner, the determining unit is specifically configured to: determine the total energy of the M sub-bands and energy of a first sub-band according to the original envelope values of the M sub-bands, where the energy of the first sub-band is the largest in that of the M sub-bands; and determine a ratio of the energy of the first sub-band to the total energy of the M sub-bands as the second parameter.

In a possible implementation manner, the modification unit is specifically configured to: determine the total energy of the M sub-bands and the energy of the first sub-band according to the original envelope values of the M sub-bands, where the energy of the first sub-band is the largest in that of the M sub-bands; determine a modification factor according to the total energy of the M sub-bands and the energy of the first sub-band; and perform modification on the original envelope values of the M sub-bands by using the modification factor, so as to acquire the modified envelope values of the M sub-bands.

In a possible implementation manner, a modified envelope value of each sub-band in the M sub-bands is greater than an original envelope value of the same sub-band.

In a possible implementation manner, the determining unit is further configured to determine a quantity of redundant bits of each sub-band in the N sub-bands according to quantities of bits respectively allocated to the N sub-bands during the first bit allocation, where the quantity of redundant bits of each sub-band in the N sub-bands is less than a quantity of bits required for encoding a single information unit in the same sub-band; the determining unit is further configured to determine a total quantity of redundant bits according to the quantity of redundant bits of each sub-band in the N sub-bands; and the allocation unit is further configured to perform second bit allocation on the N sub-bands according to the modified envelope values of the M sub-bands, the original envelope values of the K sub-bands, and the total quantity of redundant bits.

In the present invention, bit allocation is not directly performed according to original envelope values of N sub-bands; instead, M sub-bands of a low frequency band are selected from the N sub-bands, it is determined, according to an energy characteristic and a spectral characteristic that are of the M sub-bands, to perform a modification operation on original envelope values of the M sub-bands, modification is performed respectively on the original envelope values of the M sub-bands according to the original envelope values of the M sub-bands, and first bit allocation is performed on the N sub-bands according to modified envelope values of the M sub-bands and original envelope values of K sub-bands, so that bit allocation better meets a bit requirement of each sub-band, and therefore, signal encoding and decoding performance can be improved.

## BRIEF DESCRIPTION OF DRAWINGS

To describe the technical solutions of the present invention more clearly, in the following the accompanying drawings are briefly introduced describing embodiments of the present invention. Apparently, the accompanying drawings in the following description show merely some preferred embodiments of the present invention.

FIG. 1 is a schematic flowchart of a signal processing method according to an embodiment of the present invention;
FIG. 2 is a schematic flowchart of a process of a signal processing method according to an embodiment of the present invention;
FIG. 3 is a schematic block diagram of a signal processing device according to an embodiment of the present invention; and
FIG. 4 is a schematic block diagram of a signal processing device according to another embodiment of the present invention.

## DESCRIPTION OF EMBODIMENTS

The following clearly describes the technical solutions of the present invention with reference to the accompanying drawings showing preferred embodiments of the present invention. Apparently, the described embodiments are some but not all of the embodiments of the present invention.

All following occurrences of the word "embodiment(s)", if referring to feature combinations different from those defined by the independent claims, refer to examples which were originally filed but which do not represent embodiments of the presently claimed invention; these examples are still shown for illustrative purposes only.

A signal encoding technology and a signal decoding technology are widely applied to various electronic devices, such as a mobile phone, a wireless apparatus, a personal data assistant (Personal Data Assistant, PDA), a handheld or portable computer, a Global Positioning System (Global Positioning System, GPS) receiver/navigation assistant, a camera, an audio/video player, a video camera, a video recorder, and a monitoring device. Generally, such electronic devices include a speech encoder or an audio encoder, and may further include a speech decoder or an audio decoder. The speech encoder or the audio encoder and the speech decoder or the audio decoder may be directly implemented by a digital circuit or a chip, such as a digital signal processor (Digital Signal Processor, DSP) chip, or may be implemented by a software code-driven processor by executing a procedure in software code.

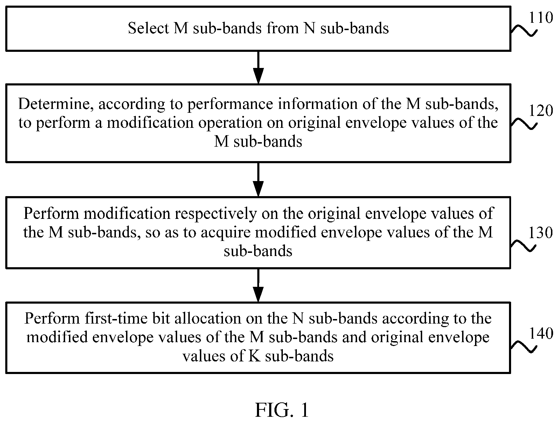

FIG. 1 is a schematic flowchart of a signal processing method according to an embodiment of the present invention. The method in FIG. 1 is executed by an encoder side, such as the foregoing speech encoder or the foregoing audio encoder. The method in FIG. 1 may also be executed by a decoder side, such as the foregoing speech decoder or the foregoing audio decoder.

In an encoding process, the encoder side may first transform a time-domain signal into a frequency-domain signal. For example, time-frequency transformation may be performed by using an algorithm such as fast Fourier transform (Fast Fourier Transform, FFT) or modified discrete cosine transform (Modified Discrete Cosine Transform, MDCT). Then, a global gain may be used to perform normalization on a spectral coefficient of the frequency-domain signal, and division is performed on a normalized spectral coefficient so as to obtain multiple sub-bands.

In a decoding process, the decoder side may decode a bitstream received from the encoder side to obtain a normalized spectral coefficient, and division is performed on the normalized spectral coefficient so as to obtain multiple sub-bands.

110. Select M sub-bands from N sub-bands, where the N sub-bands are obtained by dividing spectral coefficients of a current frame of a signal, a frequency band of the M sub-bands is lower than a frequency band of K sub-bands in the N sub-bands except the M sub-bands, N is a positive integer greater than 1, both M and K are positive integers, and the sum of M and K is N.

In this embodiment of the present invention, the signal may be a speech signal, or may be an audio signal. The foregoing K sub-bands are all sub-bands in the N sub-bands except the M sub-bands.

120. Determine, according to performance information of the M sub-bands, to perform a modification operation on original envelope values of the M sub-bands, where the performance information is used to indicate an energy characteristic and a spectral characteristic that are of the M sub-bands.

130. Perform modification respectively on the original envelope values of the M sub-bands, so as to acquire modified envelope values of the M sub-bands.

140. Perform first bit allocation on the N sub-bands according to the modified envelope values of the M sub-bands and original envelope values of the K sub-bands.

In this embodiment of the present invention, bit allocation is not directly performed according to original envelope values of N sub-bands; instead, M sub-bands of a low frequency band are selected from the N sub-bands, it is determined, according to an energy characteristic and a spectral characteristic that are of the M sub-bands, to perform a modification operation on original envelope values of the M sub-bands, modification is performed respectively on the original envelope values of the M sub-bands according to the original envelope values of the M sub-bands, and first bit allocation is performed on the N sub-bands according to modified envelope values of the M sub-bands and original envelope values of K sub-bands, so that bit allocation better meets a bit requirement of each sub-band, and therefore, signal encoding and decoding performance can be improved.

Specifically, in an existing frequency domain encoding algorithm, bit allocation is performed on each sub-band of a signal directly according to a size of a frequency envelope. As a result, a quantity of allocated bits cannot well meet a bit requirement of some sub-bands of a low frequency band. However, in this embodiment of the present invention, the M sub-bands of the low frequency band are first selected from the N sub-bands, it is determined, according to the energy characteristic and the spectral characteristic that are of the M sub-bands, to perform a modification operation on the original envelope values of the M sub-bands, modification is performed on the original envelope values of the M sub-bands according to the original envelope values of the M sub-bands, and then the first bit allocation is performed on the N sub-bands according to the modified envelope values of the M sub-bands and the original envelope values of the K sub-bands. It may be learned that, in this embodiment of the present invention, bit allocation is not directly performed on the N sub-bands according to the original envelope values of the N sub-bands. Instead, the energy characteristic and the spectral characteristic that are of the M sub-bands are used as considerations to determine that modification needs to be performed on the M sub-bands, so as to obtain the respective modified envelope values of the M sub-bands, and bit allocation is performed according to the modified envelope values of the sub-bands of the low frequency band and original envelope values of other sub-bands, so that bit allocation performed on each sub-band is more proper, especially that performed on the M sub-bands of the low frequency band, and therefore, signal encoding and decoding performance can be improved.

After the spectral coefficients are divided to obtain the N sub-bands, an envelope of each sub-band may be calculated and quantized. Therefore, each sub-band has a quantized envelope value. It should be understood that an original envelope value is relative to a modified envelope value, and the original envelope value may refer to an initial envelope value of a sub-band, that is, a quantized envelope value obtained by calculation after sub-band division. An envelope value obtained after the initial envelope value of the sub-band is modified is referred to as the modified envelope value. Therefore, in this embodiment of the present invention, both the mentioned original envelope value and modified envelope value refer to quantized envelope values.

Optionally, as an embodiment, in step 110, the M sub-bands may be selected from the N sub-bands according to a harmonic characteristic of a sub-band and energy of a sub-band. For example, for the M sub-bands, harmonic strength of each sub-band may be greater than a preset strength threshold, and a ratio of energy of the sub-band to total energy of the N sub-bands is greater than a preset energy threshold. As mentioned above, sub-bands of a low frequency band are generally a bottleneck of signal encoding performance. In these sub-bands, a sub-band that has a relatively strong harmonic characteristic and whose energy accounts for a specific proportion of total energy of all sub-bands is particularly a bottleneck of encoding performance. Therefore, after the M sub-bands are selected from the N sub-bands according to the harmonic characteristic of the sub-band and the energy of the sub-band, and the original envelope values of the M sub-bands are modified, bit allocation performed on the M sub-bands is more proper, and therefore, signal encoding and decoding performance can be efficiently improved.

Optionally, as another embodiment, the N sub-bands may be arranged in ascending order of frequency bands. In this way, in step 110, the first M sub-bands may be selected from the N sub-bands. In this embodiment, the M sub-bands are selected in ascending order of frequency bands, which can simplify an operation and improve signal processing efficiency.

In step 120, a first parameter may be determined according to the original envelope values of the N sub-bands, where the first parameter may indicate a concentration degree that is of spectral energy of the signal and that is on the M sub-bands. A second parameter may be determined according to the original envelope values of the M sub-bands, where the second parameter indicates a degree of spectral fluctuation of the M sub-bands. In a case in which the first parameter falls within a first range and the second parameter falls within a second range, it may be determined to perform a modification operation on the original envelope values of the M sub-bands.

Specifically, the energy characteristic of the M sub-bands may be the concentration degree that is of the spectral energy of the signal and that is on the M sub-bands, and the spectral characteristic of the M sub-bands may be the degree of spectral fluctuation of the M sub-bands.

The first range is related to energy of a sub-band, and may be preset. When the concentration degree that is of the spectral energy of the signal and that is on the M sub-bands is relatively low, it may indicate that a ratio of the M sub-bands to the N sub-bands is small, and the encoding performance is not greatly affected. Therefore, there is no need to modify the original envelope values of the M sub-bands. When the concentration degree that is of the spectral energy of the signal and that is on the M sub-bands is relatively high, it indicates that the original envelope values of the M sub-bands are also relatively large. Therefore, a quantity of bits allocated to the M sub-bands is enough for encoding, and there is also no need to modify the original envelope values of the M sub-bands. The first range may be predetermined by means of experimental simulation. For example, the first range may be preset to [1/6, 2/3].

The second range is related to a degree of spectral fluctuation of a sub-band, and may be preset. If the degree of spectral fluctuation of the M sub-bands is low, the encoding performance is not greatly affected even if the quantity of bits allocated to the M sub-band is small. In this way, there is no need to modify the original envelope values of the M sub-bands. Therefore, the second range indicates that the degree of spectral fluctuation of the sub-bands is relatively high. The second range may be predetermined by means of experimental simulation. For example, the second range may be preset to $\left[\dfrac{1}{0.575 * M}, \infty\right)$ or $\left[\dfrac{1}{0.5 * M}, \infty\right)$. Generally, if in a signal, bandwidth that can be used for encoding is 0 to 4 KHz, the second range may be preset to $\left[\dfrac{1}{0.575 * M}, \infty\right)$; if in a signal, bandwidth that can be used for encoding is 0 to 8 KHz, the second range may be preset to $\left[\dfrac{1}{0.5 * M}, \infty\right)$.

When the first parameter falls within the first range and the second parameter falls within the second range, it means that the concentration degree that is of the spectral energy of the signal and that is on the M sub-bands is neither extremely high nor extremely low, and that the degree of spectral fluctuation of the M sub-bands is relatively high, and modification may be performed on the original envelope values of the M sub-bands, so that bits allocated to the M sub-bands during the first bit allocation of the M sub-bands better meet a bit requirement of the M sub-bands. For example, for each sub-band in the M sub-bands, a modified envelope value is greater than an original envelope value. Then, compared with performing first bit allocation according to the original envelope values of the M sub-bands, performing first bit allocation according to the modified envelope values of the M sub-bands makes a quantity of bits allocated to the M sub-bands be larger, and therefore, encoding performance of the M sub-bands can be improved.

It may be learned that, in this embodiment, the first parameter and the second parameter that are determined according to the original envelope values of the N sub-bands may reflect a characteristic of each frequency band. Therefore, in a case in which the first parameter falls within the first range and the second parameter falls within the second range, it is determined to perform a modification operation on the original envelope values of the M sub-bands, so that when bit allocation is subsequently performed according to the modified envelope values of the M sub-bands, a quantity of bits allocated to the M sub-bands better meets a bit requirement of the M sub-bands, and therefore, signal encoding and decoding performance can be improved.

Optionally, as another embodiment, in step 120, total energy of the M sub-bands may be determined according to the original envelope values of the M sub-bands. Total energy of the K sub-bands may be determined according to the original envelope values of the K sub-bands. A ratio of the total energy of the M sub-bands to the total energy of the K sub-bands may be determined as the first parameter.

Specifically, the ratio of the total energy of the M sub-bands to the total energy of the K sub-bands may be determined as the first parameter.

For example, the first parameter may be obtained by calculation according to the following equations, where the first parameter may be represented by $\alpha$ :

$$\alpha = \frac{E_{P_M}}{E_{P_K}},$$

$$E_{P_M} = \sum_{i=0}^{M-1} E_{P\_tmp_i}, \quad E_{P_K} = \sum_{i=M}^{N-M-1} E_{P\_tmp_i},$$

$$E_{P\_tmp_i} = \sqrt{\frac{E_{P_i}}{band\_width_i}}, \text{ and } E_{P_i} = 2^{band\_energy_i},$$

where

$E_{PM}$ may represent the total energy of the M sub-bands, $E_{PK}$ may represent the total energy of the K sub-bands, $band\_width_i$ may represent bandwidth of the $i^{th}$ sub-band, and $band\_energy_i$ may represent energy of the $i^{th}$ sub-band. $band\_energy_i$ may represent an original envelope value of the $i^{th}$ sub-band. For example, the original envelope value $band\_energy_i$ of the $i^{th}$ sub-band may be obtained according to a spectral coefficient of the $i^{th}$ sub-band. For example, $band\_energy_i$ may be obtained according to the following equations:

$$band\_energy_i = \log_2 E_i,$$

and

$$E_i = \sum_{i=1}^{band\_width_i} t\_audio[j] * t\_audio[j].$$

It should be understood that persons skilled in the art can apparently make various equivalent modifications or changes according to the foregoing equations, to obtain the first parameter, and such modifications or changes also fall within this embodiment of the present invention.

Optionally, as another embodiment, in step 120, according to the original envelope values of the M sub-bands, total energy of the M sub-bands may be determined, and energy of a first sub-band may be determined, where the energy of the first sub-band is the largest in that of the M sub-bands. A ratio of the energy of the first sub-band to the total energy of the M sub-bands may be determined as the second parameter.

Specifically, the degree of spectral fluctuation of the M sub-bands may be indicated by using a fluctuation degree of the original envelope values of the M sub-bands. For example, the second parameter may be obtained by calculation according to the following equations, where the second parameter may be represented by $\beta$:

$$\beta = \frac{E_{P\_peak}}{E_{P_M}}, \text{ and } E_{P\_peak} = \max(E_{p\_tem_0}, E_{p\_tmp_1}, \cdots E_{p\_tmp_M}),$$

where

for calculation manners of $E_{P\_tmp_i}$ and $E_{PM}$, reference may be made to the foregoing equations.

It should be understood that persons skilled in the art can apparently make various equivalent modifications or changes according to the foregoing equations, to obtain the second parameter, and such modifications or changes also fall within a scope of this embodiment of the present invention.

Optionally, as another embodiment, in step 130, total energy of the M sub-bands and energy of a first sub-band may be determined according to the original envelope values of the M sub-bands, where the energy of the first sub-band is the largest in that of the M sub-bands. A modification factor may be determined according to the total energy of the M sub-bands and the energy of the first sub-band. Then, modification may be performed respectively on the original envelope values of the M sub-bands by using the modification factor, so as to acquire the modified envelope values of the M sub-bands.

For example, the modification factor may be determined according to the following equations, where the modification factor may be represented by $\gamma$:

$$\gamma = \min(1.2, \gamma_0 * \frac{E_{P\_peak} * M}{E_{P_M}}),$$

and $\gamma_0 = 0.575$, where

for calculation manners of $E_{P\_tmp_i}$ and $E_{P_M}$, reference may be made to the foregoing equations.

Modification may be performed on an original envelope value of each sub-band in the M sub-bands according to the modification factor $\gamma$. For example, the original envelope value of each sub-band may be multiplied by the modification factor, so as to obtain a modified envelope value of the sub-band.

It should be understood that persons skilled in the art can apparently make various equivalent modifications or changes according to the foregoing equations, to obtain the modification factor, and such modifications or changes also fall within this embodiment of the present invention.

Optionally, as another embodiment, in step 130, a modified envelope value of each sub-band in the M sub-bands may be greater than an original envelope value of the sub-band.

Specifically, the modified envelope value of each sub-band in the M sub-bands is obtained by performing modification on the original envelope value of each sub-band in the M sub-bands. The modified envelope value of each sub-band may be greater than the original envelope value of the sub-band. If the modified envelope value of each sub-band in the M sub-bands is greater than the original envelope value of the sub-band, in step 140, bit allocation is performed according to the modified envelope values of the M sub-bands. In this way, a quantity of bits allocated to each sub-band in the M sub-bands increases, so that the bit allocation better meets a bit requirement of each sub-band, and therefore, signal encoding and decoding performance can be improved.

Optionally, as another embodiment, in step 130, a modified envelope value of each sub-band in the M sub-bands may be less than an original envelope value of the sub-band.

Specifically, if the modified envelope value of each sub-band in the M sub-bands is less than the original envelope value of the sub-band, in step 140, bit allocation is performed according to the modified envelope values of the M sub-bands and original envelope values of the K sub-bands. In this way, a quantity of bits allocated to each sub-band in the M sub-bands is relatively small, and accordingly, quantities of bits respectively allocated to the K sub-bands increase, so that the bit allocation better meets a bit requirement of each sub-band, and therefore, signal encoding and decoding performance can be improved.

Optionally, as another embodiment, in step 130, first bit allocation may be performed on the N sub-bands in descending order of envelope values.

Optionally, as another embodiment, in step 130, a modification factor may be determined according to the second parameter. Then, modification may be performed respectively on the original envelope values of the M sub-bands by using the modification factor, so as to acquire the modified envelope values of the M sub-bands.

Specifically, the modification factor may be determined according to the second parameter. Modification may be performed on an original envelope value of each sub-band in the M sub-bands according to the modification factor. For example, the original envelope value of each sub-band may be multiplied by the modification factor to obtain a modified envelope value of the sub-band, so that a quantity of bits allocated to the M sub-bands better meets a bit requirement of the M sub-bands, and therefore, signal encoding and decoding performance can be improved.

After the first bit allocation is performed, generally, there are redundant bits in bits allocated to each sub-band. Redundant bits of each sub-band are not enough for encoding one information unit of the sub-band. Therefore, quantities of redundant bits of all sub-bands may be counted to obtain a total quantity of redundant bits, and then second bit allocation is performed.

Optionally, as another embodiment, after step 140, a quantity of redundant bits of each sub-band in the N sub-bands may be determined according to quantities of bits respectively allocated to the N sub-bands during the first bit allocation, where the quantity of redundant bits of each sub-band in the N sub-bands is less than a quantity of bits required for encoding in the same sub-band. A total quantity of redundant bits may be determined according to the quantity of redundant bits of each sub-band in the N sub-bands. Then, second bit allocation may be performed on the N sub-bands according to the total quantity of redundant bits.

Specifically, total redundant bits may be equally allocated to the N sub-bands. In this way, redundant bits may be reused, so as to avoid a waste of bits and further improve signal encoding and decoding performance.

The foregoing describes a process of first bit allocation and second bit allocation. If the foregoing method in FIG. 1 is executed by an encoder side, after the second bit allocation, the encoder side may quantize a spectral coefficient of each sub-band by using a quantity of bits allocated to each sub-band in a process of the two times bit allocation, write an index of a quantized spectral coefficient and an index of an original envelope value of each sub-band into a bitstream, and then send the bitstream to a decoder side.

If the foregoing method in FIG. 1 is executed by a decoder side, after the second bit allocation, the decoder side may decode a quantized spectral coefficient by using a quantity of bits allocated to each sub-band in a process of the two times bit allocation, so as to obtain a recovered signal.

The following describes embodiments of the present invention in detail with reference to specific examples. It should be understood that, these examples are merely intended to help persons skilled in the art better understand the embodiments of the present invention, but are not intended to limit the scope of the embodiments of the present invention.

In the following examples, an encoder side is used as an example for description.

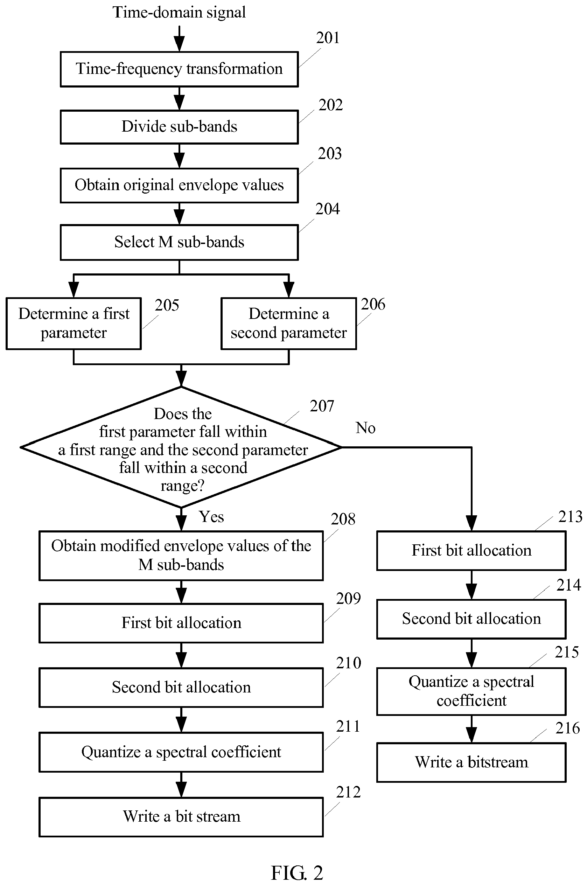

FIG. 2 is a schematic flowchart of a process of a signal processing method according to an embodiment of the present invention.

201. An encoder side performs time-frequency transformation on a time-domain signal.

202. The encoder side divides spectral coefficients of a frequency-domain signal into N sub-bands, where N is a positive integer greater than 1.

Specifically, the encoder side may calculate a global gain; the global gain is used to perform normalization on an original spectral coefficient; then, division is performed on a normalized spectral coefficient so as to obtain all sub-bands.

203. The encoder side obtains an original envelope value of each sub-band by means of a calculation operation and a quantization operation.

204. The encoder side selects M sub-bands from the N sub-bands, where M is a positive integer.

A frequency band of the M sub-bands is lower than a frequency band of K sub-bands in the N sub-bands except the M sub-bands, where K is a positive integer, and the sum of K and M is N.

205. The encoder side determines a first parameter according to original envelope values of the M sub-bands and original envelope values of K sub-bands.

The first parameter may indicate a concentration degree that is of spectral energy of the signal and that is on the M sub-bands. For example, a ratio of total energy of the M sub-bands to total energy of the K sub-bands may be used to indicate the first parameter. For a calculation manner of the first parameter, reference may be made to the calculation manner of the first parameter in the embodiment of FIG. 1, and details are not described again.

206. The encoder side determines a second parameter according to the original envelope values of the M sub-bands.

The second parameter may indicate a degree of spectral fluctuation of the M sub-bands. For example, a ratio of energy of a first sub-band to the total energy of the M sub-bands may be used to indicate the second parameter, where the energy of the first sub-band is the largest in that of the M sub-bands. For a calculation manner of the second parameter, reference may be made to the calculation manner of the second parameter in the embodiment of FIG. 1, and details are not described again.

207. The encoder side determines whether the first parameter falls within a first range and the second parameter falls within a second range.

The first range and the second range may be preset. For example, the first range may be preset to [1/6, 2/3].

The second range may be preset to $\left[\dfrac{1}{0.575 * M}, \infty\right)$ or $\left[\dfrac{1}{0.5 * M}, \infty\right)$.

208. If the encoder side determines that the first parameter falls within the first range and the second parameter falls within the second range in step 207, modify the original envelope values of the M sub-bands according to the original envelope values of the M sub-bands, so as to obtain modified envelope values of the M sub-bands.

Specifically, the encoder side may determine a modification factor according to the original envelope values of the M sub-bands. For a calculation manner of the modification factor, reference may be made to the process in the embodiment of FIG. 1, and details are not described again. The encoder side may perform modification on an original envelope value of each sub-band in the M sub-bands by using the modification factor, so as to obtain the modified envelope values of the M sub-bands. For example, a modified envelope value of each sub-band may be greater than the original envelope value of the sub-band.

209. The encoder side performs first bit allocation on the N sub-bands according to the modified envelope values of the M sub-bands and the original envelope values of the K sub-bands.

For example, the encoder side may perform first bit allocation on the N sub-bands in descending order of envelope values. For the M sub-bands, because the modified envelope value of each sub-band is greater than the original envelope value of the sub-band, compared with a quantity of allocated bits before modification, a quantity of bits allocated to each sub-band in the M sub-bands increases, so that bit allocation better meets a bit requirement of each sub-band, thereby improving signal encoding and decoding performance.

210. The encoder side performs second bit allocation on the N sub-bands.

Specifically, the encoder side may determine a quantity of redundant bits of each sub-band according to a quantity of bits allocated to each sub-band in the N sub-bands after the first bit allocation and bandwidth of each sub-band, so as to determine a total quantity of redundant bits of the N sub-bands. Then, total redundant bits are equally allocated to the N sub-bands according to the total quantity of redundant bits.

211. The encoder side quantizes a spectral coefficient of each sub-band according to a quantity of bits allocated to each sub-band in the N sub-bands.

212. The encoder side writes a bitstream according to a quantized spectral coefficient obtained in step 211 and an original envelope value of each sub-band.

Specifically, the encoder side may write indexes of the quantized spectral coefficient, the original envelope value of each sub-band, and the like into the bitstream. For a specific process, reference may be made to the prior art, and details are not described herein again.

213. If the encoder side determines that the first parameter falls outside the first range or the second parameter falls outside the second range in step 207, the encoder side performs first bit allocation on the N sub-bands according to original envelope values of the N sub-bands.

For example, the encoder side may perform first bit allocation on the N sub-bands in descending order of envelope values.

214. The encoder side performs second bit allocation on the N sub-bands.

Specifically, the encoder side may determine a quantity of redundant bits of each sub-band according to a quantity of bits allocated to each sub-band in the N sub-bands after the first bit allocation and bandwidth of each sub-band, so as to determine a total quantity of redundant bits of the N sub-bands. Then, total redundant bits are equally allocated to the N sub-bands according to the total quantity of redundant bits.

215. The encoder side quantizes a spectral coefficient of each sub-band according to a quantity of bits allocated to each sub-band in the N sub-bands.

216. The encoder side writes a bitstream according to a quantized spectral coefficient obtained in step 215 and an original envelope value of each sub-band.

Specifically, the encoder side may write indexes of the quantized spectral coefficient, the original envelope value of each sub-band, and the like into the bitstream. For a specific process, reference may be made to the prior art, and details are not described herein again.

In this embodiment of the present invention, in a case in which a first parameter falls within a first range and a second parameter falls within a second range, modification is performed on original envelope values of M sub-bands of a low frequency band according to the original envelope values of the M sub-bands, and first bit allocation is performed on N sub-bands according to modified envelope values of the M sub-bands and original envelope values of K sub-bands, so that bit allocation better meets a bit requirement of each sub-band, and therefore, signal encoding and decoding performance can be improved.

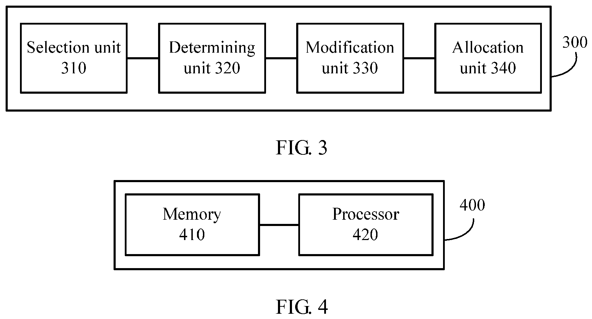

FIG. 3 is a schematic block diagram of a signal processing device according to an embodiment of the present invention. A device 300 in FIG. 3 may be an encoder side device or a decoder side device. The device 300 in FIG. 3 includes a selection unit 310, a determining unit 320, a modification unit 330, and an allocation unit 340.

The selection unit 310 selects M sub-bands from N sub-bands, where the N sub-bands are obtained by dividing spectral coefficients of a current frame of a signal, a frequency band of the M sub-bands is lower than a frequency band of K sub-bands in the N sub-bands except the M sub-bands, N is a positive integer greater than 1, both M and K are positive integers, and the sum of M and K is N. The determining unit 320 determines, according to performance information of the M sub-bands, to perform a modification operation on original envelope values of the M sub-bands, where the performance information is used to indicate an energy characteristic and a spectral characteristic that are of the M sub-bands. The modification unit 330 performs modification respectively on the original envelope values of the M sub-bands, so as to acquire modified envelope values of the M sub-bands. The allocation unit 340 performs first bit allocation on the N sub-bands according to the modified envelope values of the M sub-bands and original envelope values of the K sub-bands.

In this embodiment of the present invention, bit allocation is not directly performed according to original envelope values of N sub-bands; instead, M sub-bands of a low frequency band are selected from the N sub-bands, it is determined, according to an energy characteristic and a spectral characteristic that are of the M sub-bands, to perform a modification operation on original envelope values of the M sub-bands, modification is performed respectively on the original envelope values of the M sub-bands according to the original envelope values of the M sub-bands, and first bit allocation is performed on the N sub-bands according to modified envelope values of the M sub-bands and original envelope values of K sub-bands, so that bit allocation better meets a bit requirement of each sub-band, and therefore, signal encoding and decoding performance can be improved.

The determining unit 320 may determine a first parameter according to original envelope values of the N sub-bands, where the first parameter indicates a concentration degree that is of spectral energy of the signal and that is on the M sub-bands. The determining unit 320 may determine a second parameter according to the original envelope values of the M sub-bands, where the second parameter indicates a degree of spectral fluctuation of the M sub-bands. The determining unit 320 may determine, in a case in which the first parameter falls within a first range and the second parameter falls within a second range, to perform the modification operation on the original envelope values of the M sub-bands.

Optionally, as another embodiment, the determining unit 320 may determine total energy of the M sub-bands according to the original envelope values of the M sub-bands, may determine total energy of the K sub-bands according to the original envelope values of the K sub-bands, and may determine a ratio of the total energy of the M sub-bands to the total energy of the K sub-bands as the first parameter.

Optionally, as another embodiment, the determining unit 320 may determine total energy of the M sub-bands and energy of a first sub-band according to the original envelope values of the M sub-bands, where the energy of the first sub-band is the largest in that of the M sub-bands. The determining unit 320 may determine a ratio of the energy of the first sub-band to the total energy of the M sub-bands as the second parameter.

Optionally, as another embodiment, the modification unit 330 may determine total energy of the M sub-bands and energy of a first sub-band according to the original envelope values of the M sub-bands, where the energy of the first sub-band is the largest in that of the M sub-bands. The modification unit 330 may determine a modification factor according to the total energy of the M sub-bands and the energy of the first sub-band, and may perform modification respectively on the original envelope values of the M sub-bands by using the modification factor, so as to acquire the modified envelope values of the M sub-bands.

Optionally, as another embodiment, a modified envelope value of each sub-band in the M sub-bands may be greater than an original envelope value of the same sub-band.

Optionally, as another embodiment, the determining unit 320 may further determine a quantity of redundant bits of each sub-band in the N sub-bands according to quantities of bits respectively allocated to the N sub-bands during the first bit allocation, where the quantity of redundant bits of each sub-band in the N sub-bands is less than a quantity of bits required for encoding a single information unit in the same sub-band. The determining unit 320 may further determine a total quantity of redundant bits according to the quantity of redundant bits of each sub-band in the N sub-bands. The allocation unit 340 may further perform second bit allocation on the N sub-bands according to the modified envelope values of the M sub-bands, the original envelope values of the K sub-bands, and the total quantity of redundant bits.

For other functions and operations of the device 300, reference may be made to the processes of the method embodiments in FIG. 1 and FIG. 2. To avoid repetition, details are not described herein again.

FIG. 4 is a schematic block diagram of a signal processing device according to another embodiment of the present invention. A device 400 in FIG. 4 may be an encoder side device or a decoder side device. The device 400 in FIG. 4 includes a memory 410 and a processor 420.

The memory 410 may include a random access memory, a flash memory, a read-only memory, a programmable read-only memory, a non-volatile memory, a register, or the like. The processor 420 may be a central processing unit (Central Processing Unit, CPU).

The memory 410 is configured to store an executable instruction. The processor 420 may execute the executable instruction stored in the memory 410, so as to: select M sub-bands from N sub-bands, where the N sub-bands are obtained by dividing spectral coefficients of a current frame of a signal, a frequency band of the M sub-bands is lower than a frequency band of K sub-bands in the N sub-bands except the M sub-bands, N is a positive integer greater than 1, both M and K are positive integers, and the sum of M and K is N; determine, according to performance information of the M sub-bands, to perform a modification operation on original envelope values of the M sub-bands, where the performance information is used to indicate an energy characteristic and a spectral characteristic that are of the M sub-bands; perform modification respectively on the original envelope values of the M sub-bands, so as to acquire modified envelope values of the M sub-bands; and perform first bit allocation on the N sub-bands according to the modified envelope values of the M sub-bands and original envelope values of the K sub-bands.

In this embodiment of the present invention, bit allocation is not directly performed according to original envelope values of N sub-bands; instead, M sub-bands of a low frequency band are selected from the N sub-bands, it is determined, according to an energy characteristic and a spectral characteristic that are of the M sub-bands, to perform a modification operation on original envelope values of the M sub-bands, modification is performed respectively on the original envelope values of the M sub-bands according to the original envelope values of the M sub-bands, and first bit allocation is performed on the N sub-bands according to modified envelope values of the M sub-bands and original envelope values of K sub-bands, so that bit allocation better meets a bit requirement of each sub-band, and therefore, signal encoding and decoding performance can be improved.

The processor 420 may determine a first parameter according to original envelope values of the N sub-bands, where the first parameter indicates a concentration degree that is of spectral energy of the signal and that is on the M sub-bands. The processor 420 may determine a second parameter according to the original envelope values of the M sub-bands, where the second parameter indicates a degree of spectral fluctuation of the M sub-bands. The processor 420 may determine, in a case in which the first parameter falls within a first range and the second parameter falls within a second range, to perform the modification operation on the original envelope values of the M sub-bands.

Optionally, as another embodiment, the processor 420 may determine total energy of the M sub-bands according to the original envelope values of the M sub-bands, may determine total energy of the K sub-bands according to the original envelope values of the K sub-bands, and may determine a ratio of the total energy of the M sub-bands to the total energy of the K sub-bands as the first parameter.

Optionally, as another embodiment, the processor 420 may determine total energy of the M sub-bands and energy of a first sub-band according to the original envelope values of the M sub-bands, where the energy of the first sub-band is the largest in that of the M sub-bands. The processor 420 may determine a ratio of the energy of the first sub-band to the total energy of the M sub-bands as the second parameter.

Optionally, as another embodiment, the processor 420 may determine total energy of the M sub-bands and energy of a first sub-band according to the original envelope values of the M sub-bands, where the energy of the first sub-band is the largest in that of the M sub-bands. The processor 420 may determine a modification factor according to the total energy of the M sub-bands and the energy of the first sub-band, and may perform modification respectively on the original envelope values of the M sub-bands by using the modification factor, so as to acquire the modified envelope values of the M sub-bands.

Optionally, as another embodiment, a modified envelope value of each sub-band in the M sub-bands may be greater than an original envelope value of the same sub-band.

Optionally, as another embodiment, the processor 420 may further determine a quantity of redundant bits of each sub-band in the N sub-bands according to quantities of bits respectively allocated to the N sub-bands during the first bit allocation, where the quantity of redundant bits of each sub-band in the N sub-bands is less than a quantity of bits required for encoding a single information unit in the same sub-band. The processor 420 may further determine a total quantity of redundant bits according to the quantity of redundant bits of each sub-band in the N sub-bands. The processor 420 may further perform second bit allocation on the N sub-bands according to the modified envelope values of the M sub-bands, the original envelope values of the K sub-bands, and the total quantity of redundant bits.

For other functions and operations of the device 400, reference may be made to the processes of the method embodiments in FIG. 1 and FIG. 2. To avoid repetition, details are not described herein again.

Persons of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. Persons skilled in the art may use different methods to implement the described functions for each particular application, but it should not be considered that the implementation goes beyond the scope of the present invention.

It may be clearly understood by persons skilled in the art that, for the purpose of convenient and brief description, for a detailed working process of the foregoing system, apparatus, and unit, reference may be made to a corresponding process in the foregoing method embodiments, and details are not described herein again.

In the several embodiments provided in the present application, it should be understood that the disclosed system, apparatus, and method may be implemented in other manners. For example, the described apparatus embodiment is merely exemplary. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual needs to achieve the objectives of the solutions of the embodiments.

In addition, functional units in the embodiments of the present invention may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of the present invention essentially, or the part contributing to the prior art, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in the embodiments of the present invention. The foregoing storage medium includes: any medium that can store program encode, such as a USB flash drive, a removable hard disk, a read-only memory (ROM, Read-Only Memory), a random access memory (RAM, Random Access Memory), a magnetic disk, or an optical disc.

The foregoing descriptions are merely specific implementation manners of the present invention, but are not intended to limit the present invention.

**Claims**

1. A signal processing method for processing a signal, wherein the signal is an audio signal or a speech signal, the signal processing method comprising:

   selecting (110) the first M sub-bands from N sub-bands, wherein the N sub-bands are obtained by dividing spectral coefficients of a current frame of the signal and are arranged in ascending order of frequency bands; determining (120), according to an energy characteristic and a spectral characteristic of the M sub-bands, to perform a modification operation on original envelope values of the M sub-bands; performing (130) modification on the original envelope values of the M sub-bands, so as to acquire modified envelope values of the M sub-bands; and performing (140) first bit allocation on the N sub-bands according to the modified envelope values of the M sub-bands and original envelope values of the other K sub-bands of the N sub-bands, wherein N is a positive integer greater than 1, both M and K are positive integers, and the sum of M and K is N; **characterized in that** the step of determining (120), according to an energy characteristic and a spectral characteristic of the M sub-bands, to perform a modification operation on original envelope values of the M sub-bands comprises:

   determining the energy characteristic of the M sub-bands according to original envelope values of the N sub-bands, wherein the energy characteristic of the M sub-bands indicates a concentration degree that is of spectral energy of the current frame of the signal and that is on the M sub-bands; determining the spectral characteristic of the M sub-bands according to the original envelope values of the M sub-bands, wherein the spectral characteristic of the M sub-bands indicates a degree of spectral fluctuation of the M sub-bands; and determining, when the energy characteristic of the M sub-bands falls within a first range and the spectral characteristic of the M sub-bands falls within a second range, to perform the modification operation on the original envelope values of the M sub-bands.

2. The method according to claim 1, wherein the first range is [1/6, 2/3].

3. The method according to claim 1 or 2, wherein the second range is $\left[ \dfrac{1}{0.575 * M}, \ \infty \right)$ or $\left[ \dfrac{1}{0.5 * M}, \infty \right)$.

4. The method according to anyone of claims 1 to 3, wherein the step of determining an energy characteristic of the M sub-bands according to original envelope values of the N sub-bands comprises:

   determining total energy of the M sub-bands according to the original envelope values of the M sub-bands; determining total energy of the K sub-bands according to the original envelope values of the K sub-bands; and determining a ratio of the total energy of the M sub-bands to the total energy of the K sub-bands as the energy characteristic of the M sub-bands.

5. The method according to anyone of claims 1 to 4, wherein the step of determining a spectral characteristic of the M sub-bands according to the original envelope values of the M sub-bands comprises:

   determining the total energy of the M sub-bands and energy of a first sub-band according to the original envelope values of the M sub-bands, wherein the energy of the first sub-band is the largest in that of the M sub-bands; and determining a ratio of the energy of the first sub-band to the total energy of the M sub-bands as the spectral characteristic of the M sub-bands.

6. The method according to any one of claims 1 to 5, wherein the step of performing (130) modification on the original envelope values of the M sub-bands, so as to acquire modified envelope values of the M sub-bands comprises:

   determining the total energy of the M sub-bands and the energy of the first sub-band according to the original envelope values of the M sub-bands, wherein the energy of the first sub-band is the largest in that of the M sub-bands;

determining a modification factor according to the total energy of the M sub-bands and the energy of the first sub-band; and

performing modification on the original envelope values of the M sub-bands by using the modification factor, so as to acquire the modified envelope values of the M sub-bands.

7. The method according to any one of claims 1 to 6, wherein a modified envelope value of each sub-band in the M sub-bands is greater than an original envelope value of the same sub-band.

8. A signal processing device (300) for processing a signal, wherein the signal is an audio signal or a speech signal, the signal processing apparatus comprising:

a selection unit (310), configured to select the first M sub-bands from N sub-bands, wherein the N sub-bands are obtained by dividing spectral coefficients of a current frame of the signal and are arranged in ascending order of frequency bands;

a determining unit (320), configured to determine, according to an energy characteristic and a spectral characteristic of the M sub-bands, to perform a modification operation on original envelope values of the M sub-bands;

a modification unit (330), configured to perform modification on the original envelope values of the M sub-bands, so as to acquire modified envelope values of the M sub-bands; and

an allocation unit (340), configured to perform first bit allocation on the N sub-bands according to the modified envelope values of the M sub-bands and original envelope values of the other K sub-bands of the N sub-bands, wherein N is a positive integer greater than 1, both M and K are positive integers, and the sum of M and K is N; **characterized in that** the determining unit (320) is specifically configured to:

determine the energy characteristic of the M sub-bands according to original envelope values of the N sub-bands, wherein the energy characteristic of the M sub-bands indicates a concentration degree that is of spectral energy of the current frame of the signal and that is on the M sub-bands;

determine the spectral characteristic of the M sub-bands according to the original envelope values of the M sub-bands, wherein the spectral characteristic of the M sub-bands indicates a degree of spectral fluctuation of the M sub-bands; and

determine, when the energy characteristic of the M sub-bands falls within a first range and the spectral characteristic of the M sub-bands falls within a second range, to perform the modification operation on the original envelope values of the M sub-bands.

9. The device (300) according to claim 8, wherein the first range is [1/6, 2/3].

10. The device (300) according to claim 8 or 9, wherein the second range is $[\frac{1}{0.575 * M}, \infty)$ or $[\frac{1}{0.5 * M}, \infty)$.

11. The device (300) according to anyone of claims 8 to 10, wherein the determining unit (320) is specifically configured to:

determine total energy of the M sub-bands according to the original envelope values of the M sub-bands;

determine total energy of the K sub-bands according to the original envelope values of the K sub-bands; and

determine a ratio of the total energy of the M sub-bands to the total energy of the K sub-bands as the energy characteristic of the M sub-bands.

12. The device (300) according to anyone of claims 8 to 11, wherein the determining unit (320) is specifically configured to:

determine the total energy of the M sub-bands and energy of a first sub-band according to the original envelope values of the M sub-bands, wherein the energy of the first sub-band is the largest in that of the M sub-bands; and

determine a ratio of the energy of the first sub-band to the total energy of the M sub-bands as the spectral characteristic of the M sub-bands.

13. The device (300) according to any one of claims 8 to 12, wherein the modification unit (330) is specifically configured to:

determine the total energy of the M sub-bands and the energy of the first sub-band according to the original envelope values of the M sub-bands, wherein the energy of the first sub-band is the largest in that of the M sub-bands;

determine a modification factor according to the total energy of the M sub-bands and the energy of the first sub-band; and

perform modification on the original envelope values of the M sub-bands by using the modification factor, so as to acquire the modified envelope values of the M sub-bands.

14. The device (300) according to any one of claims 8 to 13, wherein a modified envelope value of each sub-band in the M sub-bands is greater than an original envelope value of the same sub-band.

**Patentansprüche**

1. Signalverarbeitungsverfahren zum Verarbeiten eines Signals, wobei das Signal ein Audiosignal oder ein Sprachsignal ist, das Signalverarbeitungsverfahren umfassend:

Auswählen (110) der ersten M Teilbänder aus N Teilbändern, wobei die N Teilbänder erlangt werden durch Teilen der Spektralkoeffizienten eines aktuellen Rahmens des Signals und in aufsteigender Reihenfolge der Frequenzbänder angeordnet sind;
Bestimmen (120), gemäß einer Energiecharakteristik und einer Spektralcharakteristik der M Teilbänder, eine Modifikationsoperation ursprünglicher Hüllkurvenwerte der M Teilbänder vorzunehmen;
Vornehmen (130) einer Modifikation der ursprünglichen Hüllkurvenwerte der M Teilbänder, um modifizierte Hüllkurvenwerte der M Teilbänder zu erlangen; und
Vornehmen (140) einer ersten Bitzuweisung der N Teilbänder gemäß den modifizierten Hüllkurvenwerten der M Teilbänder und den ursprünglichen Hüllkurvenwerten der übrigen K Teilbänder der N Teilbänder, wobei N eine positive ganze Zahl größer 1 ist, M und K beide positive ganze Zahlen sind, und die Summe aus M und K N ist;
**dadurch gekennzeichnet, dass** der Schritt des Bestimmens (120), gemäß einer Energiecharakteristik und einer Spektralcharakteristik der M Teilbänder, eine Modifikationsoperation ursprünglicher Hüllkurvenwerte der M Teilbänder vorzunehmen, umfasst:

Bestimmen der Energiecharakteristik der M Teilbänder gemäß ursprünglichen Hüllkurvenwerten der N Teilbänder, wobei die Energiecharakteristik der M Teilbänder einen Konzentrationsgrad an Spektralenergie des aktuellen Rahmens des Signals auf den M Teilbändern anzeigt;
Bestimmen der Spektralcharakteristik der M Teilbänder gemäß ursprünglichen Hüllkurvenwerten der M Teilbänder, wobei die Spektralcharakteristik der M Teilbänder einen Spektralfluktuationsgrad der M Teilbänder anzeigt; und
Bestimmen, wenn die Energiecharakteristik der M Teilbänder innerhalb eines ersten Bereichs liegt und die Spektralcharakteristik der M Teilbänder innerhalb eines zweiten Bereichs liegt, die Modifikationsoperation der ursprünglichen Hüllkurvenwerte der M Teilbänder vorzunehmen.

2. Verfahren nach Anspruch 1, wobei der erste Bereich [1/6, 2/3] ist.

3. Verfahren nach Anspruch 1 oder 2, wobei der zweite Bereich $\left[\dfrac{1}{0{,}575 * M}, \infty\right)$ oder 1 $\left[\dfrac{1}{0{,}5 * M}, \infty\right)$ ist.

4. Verfahren nach einem der Ansprüche 1 bis 3, wobei der Schritt des Bestimmens einer Energiecharakteristik der M Teilbänder gemäß ursprünglichen Hüllkurvenwerte der N Teilbänder umfasst:

Bestimmen der Gesamtenergie der M Teilbänder gemäß den ursprünglichen Hüllkurvenwerten der M Teilbänder;
Bestimmen der Gesamtenergie der K Teilbänder gemäß den ursprünglichen Hüllkurvenwerten der K Teilbänder; und
Bestimmen eines Verhältnisses der Gesamtenergie der M Teilbänder zur Gesamtenergie der K Teilbänder als die Energiecharakteristik der M Teilbänder.

5. Verfahren nach einem der Ansprüche 1 bis 4, wobei der Schritt des Bestimmens einer Spektralcharakteristik der M Teilbänder gemäß den ursprünglichen Hüllkurvenwerten der M Teilbänder umfasst:

Bestimmen der Gesamtenergie der M Teilbänder und der Energie eines ersten Teilbands gemäß den ursprünglichen Hüllkurvenwerten der M Teilbänder, wobei die Energie des ersten Teilbands die größte unter jenen der M Teilbänder ist; und

Bestimmen eines Verhältnisses der Energie des ersten Teilbands zur Gesamtenergie der M Teilbänder als die Spektralcharakteristik der M Teilbänder.

6. Verfahren nach einem der Ansprüche 1 bis 5, wobei der Schritt des Vornehmens (130) einer Modifikation der ursprünglichen Hüllkurvenwerte der M Teilbänder, um modifizierte Hüllkurvenwerte der M Teilbänder zu erlangen, umfasst:

Bestimmen der Gesamtenergie der M Teilbänder und der Energie des ersten Teilbands gemäß den ursprünglichen Hüllkurvenwerten der M Teilbänder, wobei die Energie des ersten Teilbands die größte unter jenen der M Teilbänder ist;
Bestimmen eines Modifikationsfaktors gemäß der Gesamtenergie der M Teilbänder und der Energie des ersten Teilbands; und
Vornehmen einer Modifikation der ursprünglichen Hüllkurvenwerte der M Teilbänder unter Verwendung des Modifikationsfaktors, um die modifizierten Hüllkurvenwerte der M Teilbänder zu erlangen.

7. Verfahren nach einem der Ansprüche 1 bis 6, wobei ein modifizierter Hüllkurvenwert jedes der Teilbänder unter den M Teilbändern größer ist, als ein ursprünglicher Hüllkurvenwert desselben Teilbands.

8. Signalverarbeitungsvorrichtung (300) zum Verarbeiten eines Signals, wobei das Signal ein Audiosignal oder ein Sprachsignal ist, die Signalverarbeitungsvorrichtung aufweisend:

eine Auswahleinheit (310), die dafür ausgelegt ist, die ersten M Teilbänder aus N Teilbändern auszuwählen, wobei die N Teilbänder erlangt werden durch Teilen der Spektralkoeffizienten eines aktuellen Rahmens des Signals und in aufsteigender Reihenfolge der Frequenzbänder angeordnet sind;
eine Bestimmungseinheit (320), die dafür ausgelegt ist, gemäß einer Energiecharakteristik und einer Spektralcharakteristik der M Teilbänder zu bestimmen, eine Modifikationsoperation ursprünglicher Hüllkurvenwerte der M Teilbänder vorzunehmen;
eine Modifikationseinheit (330), die dafür ausgelegt ist, eine Modifikation der ursprünglichen Hüllkurvenwerte der M Teilbänder vorzunehmen, um modifizierte Hüllkurvenwerte der M Teilbänder zu erlangen; und
eine Zuweisungseinheit (340), die dafür ausgelegt ist, eine erste Bitzuweisung der N Teilbänder gemäß den modifizierten Hüllkurvenwerte der M Teilbänder und ursprünglichen Hüllkurvenwerten der übrigen K Teilbänder der N Teilbänder vorzunehmen, wobei N eine positive ganze Zahl größer als 1 ist, M und K beide positive ganze Zahlen sind, und die Summe aus M und K N ist;
**dadurch gekennzeichnet, dass** die Bestimmungseinheit (320) insbesondere dafür ausgelegt ist:

die Energiecharakteristik der M Teilbänder gemäß ursprünglichen Hüllkurvenwerten der N Teilbänder zu bestimmen, wobei die Energiecharakteristik der M Teilbänder einen Konzentrationsgrad an Spektralenergie des aktuellen Rahmens des Signals und an den M Teilbändern anzeigt;
die Spektralcharakteristik der M Teilbänder gemäß den ursprünglichen Hüllkurvenwerten der M Teilbänder zu bestimmen, wobei die Spektralcharakteristik der M Teilbänder einen Spektralfluktuationsgrad der M Teilbänder anzeigt; und
wenn die Energiecharakteristik der M Teilbänder innerhalb eines ersten Bereichs liegt und die Spektralcharakteristik der M Teilbänder innerhalb eines zweiten Bereichs liegt, zu bestimmen, die Modifikationsoperation der ursprünglichen Hüllkurvenwerte der M Teilbänder vorzunehmen.

9. Vorrichtung (300) nach Anspruch 8, wobei der erste Bereich [1/6, 2/3] ist.

10. Vorrichtung (300) nach Anspruch 8 oder 9, wobei der zweite Bereich $\left[\frac{1}{0{,}575 * M}, \infty\right)$ oder $\left[\frac{1}{0{,}5 * M}, \infty\right)$ ist.

11. Vorrichtung (300) nach einem der Ansprüche 8 bis 10, wobei die Bestimmungseinheit (320) insbesondere dafür ausgelegt ist:

die Gesamtenergie der M Teilbänder gemäß den ursprünglichen Hüllkurvenwerten der M Teilbänder zu bestimmen;
die Gesamtenergie der K Teilbänder gemäß den ursprünglichen Hüllkurvenwerten der K Teilbänder zu bestimmen; und
ein Verhältnis der Gesamtenergie der M Teilbänder zur Gesamtenergie der K Teilbänder als die Energiecharakteristik der M Teilbänder zu bestimmen.

12. Vorrichtung (300) nach einem der Ansprüche 8 bis 11, wobei die Bestimmungseinheit (320) insbesondere dafür ausgelegt ist:

die Gesamtenergie der M Teilbänder und die Energie eines ersten Teilbands gemäß den ursprünglichen Hüllkurvenwerten der M Teilbänder zu bestimmen, wobei die Energie des ersten Teilbands die größte unter jenen der M Teilbänder ist; und
ein Verhältnis der Energie des ersten Teilbands zur Gesamtenergie der M Teilbänder als die Spektralcharakteristik der M Teilbänder zu bestimmen.

13. Vorrichtung (300) nach einem der Ansprüche 8 bis 12, wobei die Modifikationseinheit (330) insbesondere dafür ausgelegt ist:

die Gesamtenergie der M Teilbänder und die Energie des ersten Teilbands gemäß den ursprünglichen Hüllkurvenwerten der M Teilbänder zu bestimmen, wobei die Energie des ersten Teilbands die größte unter jenen der M Teilbänder ist;
einen Modifikationsfaktors gemäß der Gesamtenergie der M Teilbänder und der Energie des ersten Teilbands zu bestimmen; und
eine Modifikation der ursprünglichen Hüllkurvenwerte der M Teilbänder unter Verwendung des Modifikationsfaktors vorzunehmen, um die modifizierten Hüllkurvenwerte der M Teilbänder zu erlangen.

14. Vorrichtung (300) nach einem der Ansprüche 8 bis 13, wobei ein modifizierter Hüllkurvenwert jedes der Teilbänder unter den M Teilbändern größer ist, als ein ursprünglicher Hüllkurvenwerte desselben Teilbands.

**Revendications**

1. Procédé de traitement de signal pour traiter un signal, dans lequel le signal est un signal audio ou un signal vocal, le procédé de traitement de signal comprenant les étapes consistant à :

sélectionner (110) les premières M sous-bandes parmi N sous-bandes, dans lequel les N sous-bandes sont obtenues en divisant les coefficients spectraux d'une trame actuelle du signal et sont disposées dans un ordre croissant de bandes de fréquence ;
déterminer (120), en fonction d'une caractéristique d'énergie et d'une caractéristique spectrale des M sous-bandes, d'effectuer une opération de modification sur des valeurs d'enveloppe d'origine des M sous-bandes ;
effectuer (130) une modification sur les valeurs d'enveloppe d'origine des M sous-bandes, de manière à acquérir des valeurs d'enveloppe modifiées des M sous-bandes ; et
effectuer (140) une première attribution de bits sur les N sous-bandes en fonction des valeurs d'enveloppe modifiées des M sous-bandes et des valeurs d'enveloppe d'origine des autres K sous-bandes des N sous-bandes, dans lequel N est un entier positif supérieur à 1, M et K sont tous deux des entiers positifs et la somme de M et K est N ;
**caractérisé en ce que** l'étape de détermination (120), en fonction d'une caractéristique d'énergie et d'une caractéristique spectrale des M sous-bandes, d'effectuer une opération de modification sur des valeurs d'enveloppe d'origine des M sous-bandes comprend les étapes consistant à :

déterminer la caractéristique d'énergie des M sous-bandes en fonction de valeurs d'enveloppe d'origine des N sous-bandes, dans lequel la caractéristique d'énergie des M sous-bandes indique un degré de concentration d'énergie spectrale de la trame actuelle du signal et se trouvant sur les M sous-bandes ;
déterminer la caractéristique spectrale des M sous-bandes en fonction des valeurs d'enveloppe d'origine des M sous-bandes, dans lequel la caractéristique spectrale des M sous-bandes indique un degré de fluctuation spectrale des M sous-bandes ; et
déterminer, lorsque la caractéristique d'énergie des M sous-bandes est comprise dans un premier intervalle et que la caractéristique spectrale des M sous-bandes est comprise dans un second intervalle, d'effectuer l'opération de modification sur les valeurs d'enveloppe d'origine des M sous-bandes.

2. Procédé selon la revendication 1, dans lequel le premier intervalle est [1/6, 2/3].

**3.** Procédé selon la revendication 1 ou 2, dans lequel le second intervalle est $\left[\dfrac{1}{0.575 * M}, \infty\right)$ ou $\left[\dfrac{1}{0.5 * M}, \infty\right)$.

**4.** Procédé selon l'une quelconque des revendications 1 à 3, dans lequel l'étape de détermination d'une caractéristique d'énergie des M sous-bandes en fonction de valeurs d'enveloppe d'origine des N sous-bandes comprend les étapes consistant à :

déterminer l'énergie totale des M sous-bandes en fonction des valeurs d'enveloppe d'origine des M sous-bandes ;
déterminer l'énergie totale des K sous-bandes en fonction des valeurs d'enveloppe d'origine des K sous-bandes ; et
déterminer un rapport de l'énergie totale des M sous-bandes sur l'énergie totale des K sous-bandes en tant que caractéristique d'énergie des M sous-bandes.

**5.** Procédé selon l'une quelconque des revendications 1 à 4, dans lequel l'étape de détermination d'une caractéristique spectrale des M sous-bandes en fonction des valeurs d'enveloppe d'origine des M sous-bandes comprend les étapes consistant à :

déterminer l'énergie totale des M sous-bandes et l'énergie d'une première sous-bande en fonction des valeurs d'enveloppe d'origine des M sous-bandes, dans lequel l'énergie de la première sous-bande est la plus grande de celles des M sous-bandes ; et
déterminer un rapport de l'énergie de la première sous-bande sur l'énergie totale des M sous-bandes en tant que caractéristique spectrale des M sous-bandes.

**6.** Procédé selon l'une quelconque des revendications 1 à 5, dans lequel l'étape consistant à effectuer (130) une modification sur les valeurs d'enveloppe d'origine des M sous-bandes, de manière à acquérir des valeurs d'enveloppe modifiées des M sous-bandes comprend les étapes consistant à :

déterminer l'énergie totale des M sous-bandes et l'énergie de la première sous-bande en fonction des valeurs d'enveloppe d'origine des M sous-bandes, dans lequel l'énergie de la première sous-bande est la plus grande de celles des M sous-bandes ;
déterminer un facteur de modification en fonction de l'énergie totale des M sous-bandes et de l'énergie de la première sous-bande ; et
effectuer une modification sur les valeurs d'enveloppe d'origine des M sous-bandes en utilisant le facteur de modification, de manière à acquérir les valeurs d'enveloppe modifiées des M sous-bandes.

**7.** Procédé selon l'une quelconque des revendications 1 à 6, dans lequel une valeur d'enveloppe modifiée de chaque sous-bande parmi les M sous-bandes est supérieure à une valeur d'enveloppe d'origine de la même sous-bande.

**8.** Dispositif de traitement de signal (300) pour traiter un signal, dans lequel le signal est un signal audio ou un signal vocal, l'appareil de traitement de signal comprenant :

une unité de sélection (310), configurée pour sélectionner les premières M sous-bandes parmi N sous-bandes, dans lequel les N sous-bandes sont obtenues en divisant les coefficients spectraux d'une trame actuelle du signal et sont disposées dans un ordre croissant de bandes de fréquence ;
une unité de détermination (320), configurée pour déterminer, en fonction d'une caractéristique d'énergie et d'une caractéristique spectrale des M sous-bandes, d'effectuer une opération de modification sur des valeurs d'enveloppe d'origine des M sous-bandes ;
une unité de modification (330), configurée pour effectuer une modification sur les valeurs d'enveloppe d'origine des M sous-bandes, de manière à acquérir des valeurs d'enveloppe modifiées des M sous-bandes ; et
une unité d'allocation (340), configurée pour effectuer une première attribution de bits sur les N sous-bandes en fonction des valeurs d'enveloppe modifiées des M sous-bandes et des valeurs d'enveloppe d'origine des autres K sous-bandes des N sous-bandes, dans lequel N est un entier positif supérieur à 1, M et K sont tous deux des entiers positifs et la somme de M et K est N ;
**caractérisé en ce que** l'unité de détermination (320) est spécifiquement configurée pour :

déterminer la caractéristique d'énergie des M sous-bandes en fonction de valeurs d'enveloppe d'origine des N sous-bandes, dans lequel la caractéristique d'énergie des M sous-bandes indique un degré de concentration d'énergie spectrale de la trame actuelle du signal et se trouvant sur les M sous-bandes ;

déterminer la caractéristique spectrale des M sous-bandes en fonction des valeurs d'enveloppe d'origine des M sous-bandes, dans lequel la caractéristique spectrale des M sous-bandes indique un degré de fluctuation spectrale des M sous-bandes ; et

déterminer, lorsque la caractéristique d'énergie des M sous-bandes est comprise dans un premier intervalle et que la caractéristique spectrale des M sous-bandes est comprise dans un second intervalle, d'effectuer l'opération de modification sur les valeurs d'enveloppe d'origine des M sous-bandes.

9. Dispositif (300) selon la revendication 8, dans lequel le premier intervalle est [1/6, 2/3].

10. Dispositif (300) selon les revendications 8 ou 9, dans lequel le second intervalle est 1 1 $[\frac{1}{0.575 * M}, \infty)$ or $[\frac{1}{0.5 * M}, \infty)$.

11. Dispositif (300) selon l'une quelconque des revendications 8 à 10, dans lequel l'unité de détermination (320) est en particulier configurée pour :

déterminer l'énergie totale des M sous-bandes en fonction des valeurs d'enveloppe d'origine des M sous-bandes ;

déterminer l'énergie totale des K sous-bandes en fonction des valeurs d'enveloppe d'origine des K sous-bandes ; et

déterminer un rapport de l'énergie totale des M sous-bandes sur l'énergie totale des K sous-bandes en tant que caractéristique d'énergie des M sous-bandes.

12. Dispositif (300) selon l'une quelconque des revendications 8 à 11, dans lequel l'unité de détermination (320) est en particulier configurée pour :

déterminer l'énergie totale des M sous-bandes et l'énergie d'une première sous-bande en fonction des valeurs d'enveloppe d'origine des M sous-bandes, dans lequel l'énergie de la première sous-bande est la plus grande de celles des M sous-bandes ; et

déterminer un rapport de l'énergie de la première sous-bande sur l'énergie totale des M sous-bandes en tant que caractéristique spectrale des M sous-bandes.

13. Dispositif (300) selon l'une quelconque des revendications 8 à 12, dans lequel l'unité de modification (330) est en particulier configurée pour :

déterminer l'énergie totale des M sous-bandes et l'énergie de la première sous-bande en fonction des valeurs d'enveloppe d'origine des M sous-bandes, dans lequel l'énergie de la première sous-bande est la plus grande de celles des M sous-bandes ;

déterminer un facteur de modification en fonction de l'énergie totale des M sous-bandes et de l'énergie de la première sous-bande ; et

effectuer une modification sur les valeurs d'enveloppe d'origine des M sous-bandes en utilisant le facteur de modification, de manière à acquérir les valeurs d'enveloppe modifiées des M sous-bandes.

14. Dispositif (300) selon l'une quelconque des revendications 8 à 13, dans lequel une valeur d'enveloppe modifiée de chaque sous-bande parmi les M sous-bandes est supérieure à une valeur d'enveloppe d'origine de la même sous-bande.

Select M sub-bands from N sub-bands | 110

Determine, according to performance information of the M sub-bands, to perform a modification operation on original envelope values of the M sub-bands | 120

Perform modification respectively on the original envelope values of the M sub-bands, so as to acquire modified envelope values of the M sub-bands | 130

Perform first-time bit allocation on the N sub-bands according to the modified envelope values of the M sub-bands and original envelope values of K sub-bands | 140

FIG. 1

Time-domain signal

Time-frequency transformation — 201

Divide sub-bands — 202

Obtain original envelope values — 203

Select M sub-bands — 204

Determine a first parameter — 205

Determine a second parameter — 206

Does the first parameter fall within a first range and the second parameter fall within a second range? — 207

No

Yes

Obtain modified envelope values of the M sub-bands — 208

First bit allocation — 209

Second bit allocation — 210

Quantize a spectral coefficient — 211

Write a bit stream — 212

First bit allocation — 213

Second bit allocation — 214

Quantize a spectral coefficient — 215

Write a bitstream — 216

FIG. 2

| Selection unit 310 | Determining unit 320 | Modification unit 330 | Allocation unit 340 |
|---|---|---|---|

300

FIG. 3

| Memory 410 | Processor 420 |
|---|---|

400

FIG. 4

**EP 3 079 150 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005258478 A